(19) **Europäisches Patentamt**
**European Patent Office**
**Office européen des brevets**

(11) **EP 1 659 697 B1**

(12) **EUROPEAN PATENT SPECIFICATION**

(45) Date of publication and mention
of the grant of the patent:
**30.06.2010 Bulletin 2010/26**

(51) Int Cl.:
*H03M 13/45* (2006.01)     *H04L 25/03* (2006.01)
*H04L 1/00* (2006.01)

(21) Application number: **04292746.7**

(22) Date of filing: **19.11.2004**

(54) **Receiver system and method for soft-decision decoding of punctured convolutional codes**

Empfängerssystem und -Verfahren zur Soft-Dekodierung von punktierten Faltungskoden

Système et méthode de réception pour le décodage soft de codes convolutionnels poinçonnés

(84) Designated Contracting States:
**AT BE BG CH CY CZ DE DK EE ES FI FR GB GR HU IE IS IT LI LU MC NL PL PT RO SE SI SK TR**

(43) Date of publication of application:
**24.05.2006 Bulletin 2006/21**

(73) Proprietor: **Alcatel Lucent**
**75008 Paris (FR)**

(72) Inventors:
• **McQueen, Neil**
**73207 Plochingen (DE)**
• **Nikolai, Dirk**
**70825 Korntal-Münchingen (DE)**

(74) Representative: **Schmidt, Werner Karl**
**Alcatel-Lucent**
**Intellectual Property & Standards**
**70430 Stuttgart (DE)**

(56) References cited:
**EP-A- 1 187 344**      **WO-A-2004/038946**
**WO-A-2005/013543**     **US-B1- 6 347 124**

• **BUTLER M R G ET AL: "Viterbi decoding strategies for 5 GHz wireless LAN systems" VTC FALL 2001. IEEE 54TH. VEHICULAR TECHNOLOGY CONFERENCE. PROCEEDINGS. ATLANTIC CITY, NJ, OCT. 7 - 11, 2001, IEEE VEHICULAR TECHNOLGY CONFERENCE, NEW YORK, NY : IEEE, US, vol. VOL. 1 OF 4. CONF. 54, 7 October 2001 (2001-10-07), pages 77-81, XP010562648 ISBN: 0-7803-7005-8**
• **JEAN AU ET AL: "Performance of turbo codes with quantized channel measurements" GLOBECOM 99, vol. 5, 5 December 1999 (1999-12-05), pages 2586-2591, XP010373419**

**Description**

The present invention relates to error correction coding in digital communication systems, and more particularly, to soft-decision decoding of punctured convolutional codes.

Forward error correction coding is a general technique of digital communication systems to protect the digital data from errors during transmission through a transmission channel. Data signals, in particular those transmitted over a radio transmission channel, are susceptible to errors caused by noise or interference. Error correction coding techniques enable a digital communication system to represent the data stream to be transmitted in a robust way so that the original data stream can be recovered at the receiver side even if it has been corrupted by the transmission channel.

One well-known error correction coding technique currently used in digital wireless communication systems is "punctured convolutional coding". In general, communication systems using punctured convolutional coding basically comprise an encoding means for encoding a digital input to be transmitted from a transmitter and decoding means for decoding the coded input received at the receiver. The encoding means basically comprise a "convolutional coding circuit" which receives a digital input and outputs a convolutional encoded output, and, in order to increase the code rate of the encoder, the convolutionally encoded output is passed through a "puncturing circuit" which includes a transmission mask circuit and deleting pattern memory for transmitting only selected symbols of the convolutionally encoded output. At the receiver side, the decoding means basically comprise a "de-puncturing circuit" which, knowing the position of deleted symbols, re-inserts "dummy" symbols in the relative positions, and a "convolutional decoder circuit" typically using a Viterbi algorithm and referred to as "Viterbi decoder".

Also, at the receiver side, generally a "soft-decision decoding" technique is used in order to improve the performance of the Viterbi decoder. Soft-decision decoding schemes at the receiver typically provide a better error correction capability than "hard decoding" schemes, which work only with two values or levels: "0" and "1".

Soft-decision decoding quantizes a received signal into more than two state values or levels. For example, a soft-bit decision decoding method representing the received information, or soft-bits, in "5" quantization bits, gives rise to "$2^5$=32" possible soft-decision values or levels depending on their "closeness" to either a logical "1" or "0". These additional levels provide a measure of certainty or confidence that is associated with the received signal values.

An example of a method and apparatus using soft decision decoding of punctured convolutional codes is shown in Patent Publication No. WO 2004/056058. In said document, a UMTS/GSM receiver with EDGE services capability is disclosed in which a data sequence incorporating PSK symbols is separated into bits which are assigned confidence values and input to a convolutional decoder to provide improved decoding.

The document 'Viterbi decoding strategies for 5 GHz wireless LAN systems', XP010562648, IEEE 54th vehicular technology conference proceedings, discloses a soft Viterbi decoder for puncture convolutional codes, where the soft decision values are quantized. In this document, dummy bits inserted into the receive bit stream are marked so that they do not contribute to the calculation of the path metrics.

A problem with conventional systems for soft-decision decoding of punctured convolutional codes is that they tend to provide better bit error rate (BER) performance, i.e. a lower BER, at the expense of increasing the number of quantization bits or soft-decision values used to represent the received signal. As the number of quantization bits increases, the hardware or software complexity of the decoding means increases exponentially and the number of calculations required to do decoding increases such that it is no longer practical to do decoding this way. Also decoding the data requires an additional delay. This means that the receiver systems become more expensive due to increasing decoding equipment cost and processing power.

Thus, there is a need to find a compromise between the performance level of the decoding means and the complexity of its implementation in either hardware or software.

It is the object of the invention to solve the aforesaid technical problems and provide an improved soft-decision decoding of data streams coded by means of punctured convolutional coding.

The object is achieved by a method for soft-decision decoding of punctured convolutional codes according to claim 1, a receiver system of a wireless communication system comprising a means for receiving and decoding of punctured convolutional codes according to claim 7, and a base station and a mobile station of a wireless communication system comprising the said receiver system according to claims 8 and 10.

The method for soft-decision decoding of the invention maximizes the information available at the input of the soft-decision decoder using fewer quantization bits to represent the received soft-bits. The idea is then to reduce the computational complexity and enhance the decoding capability of the decoding means by using fewer quantization bits to represent the soft-decision values in the decoding process. In order to reduce the quantization bits and soft-decision values, a "coarse" quantization (quantization in fewer levels or with fewer quantization bits) of the received signal values is needed. The invention makes use of the observation that soft-decision zero values normally do not assist the decision making process in the decoder. The basic idea of the invention is then to differentiate between soft-decision values stemming from demodulation or equalization and soft-decision zero values - dummy symbols- inserted by the de-puncturer in order to save as much soft-decision information as possible when applying a coarse quantization to the received signal soft-decision values.

According to a first preferred embodiment of the invention, all received signal soft-decision values are shifted away from the zero value by one half of the coarse quantization step, and then the coarse quantization is applied to these values according to a certain coarse quantization input-output relationship.

According to a second preferred embodiment of the invention, the received signal soft-decision values that would fall into the soft-decision zero level of the coarse quantization are shifted away from the zero level by one half of the coarse quantization step, and then the coarse quantization is applied to these values according to a certain coarse quantization input-output relationship.

Advantageous configurations of the invention emerge from the dependent claims, the following description and the drawings. For example, the device and method of the invention achieve better BER performance for a given number of quantization bits used in the decoding process compared with conventional methods for soft-decision decoding of punctured convolutional codes using the same amount of quantization bits. Further it is seen advantageous that the present invention allows to reduce the complexity, cost, size and power consumption of the decoding means typically associated with prior art methods and apparatuses for soft-decision decoding of punctured convolutional codes, for a given BER performance. By applying the method of the invention, the number of quantization bits and soft-decision values needed to represent the received signal can be reduced while maintaining the performance of the decoding means.

An embodiment-simplified example of the invention is now explained with the aid of Figures 1 to 7.

Fig. 1 illustrates a block diagram of a wireless receiving system comprising soft-decision decoding means for punctured convolutional codes according to the invention.

Fig. 2 is a graph illustrating an exemplary histogram distribution of the soft bits at the output of an equalizer.

Fig. 3 A,B,C shows by way of a histogram graph example a processing method of soft-decision values at a soft-decision processing unit according to a first embodiment of the invention.

Fig. 4 is a flow chart illustrating an operating process of a soft-decision processing unit according to a first embodiment of the invention.

Fig. 5 A,B shows quantization tables for coarse quantization of the received signal soft-decision values according to the invention.

Fig. 6 A,B,C shows by way of a histogram graph example a processing method of soft-decision values at a soft-decision processing unit according to a second embodiment of the invention.

Fig. 7 is a flow chart illustrating an operating process of a soft-decision processing unit according to a second embodiment of the invention.

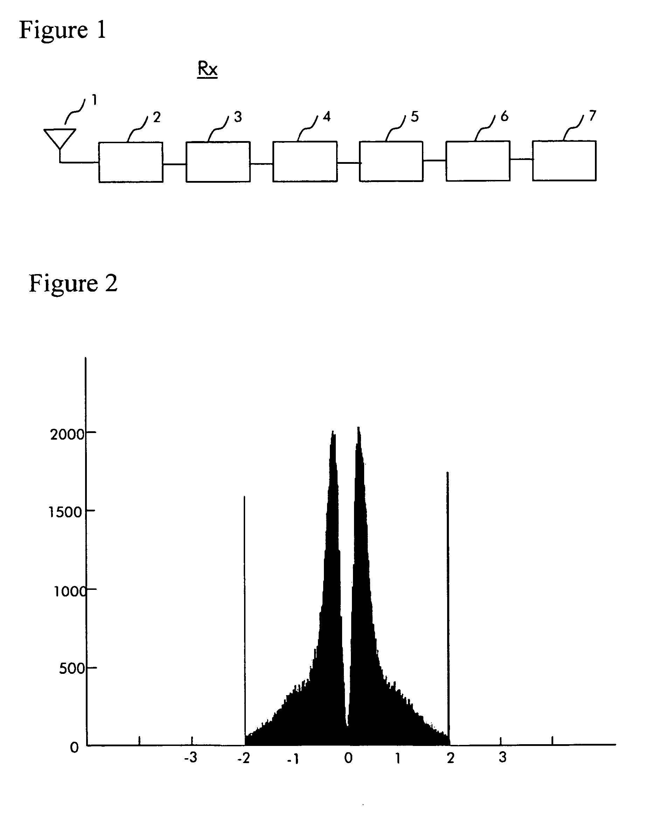

Figure 1 shows a block diagram of an exemplary wireless receiving system Rx for receiving and decoding a transmitted signal which has been coded by punctured convolutional coding. Receiving system Rx comprises a receive antenna 1 that provides the received signals to a demodulator 2. The demodulator outputs a demodulated signal to an equalizer 3, which provides equalized soft-decision bit values to a soft-decision processing unit 4 according to the invention. The soft-decision processing unit 4 outputs soft-decision values to a de-puncturing circuit 5, where zero value indicatives are then inserted for punctured coded bits, and then the values are passed to a de-interleaving circuit 6 and convolutional decoder 7.

It is understood that the channel demodulation, de-puncturing, de-interleaving and decoding are complementary to the channel modulation interleaving, puncturing, and encoding performed at the corresponding transmitting system. The design of the receiving system Rx and the elements it comprises is typically dependent on the particular coding scheme used at the transmitter.

Representation of the symbols at the output of the demodulator 2 and/or equalizer 3 is done using multiple bits and it is referred to as "soft-decision data", represented by a number "soft-decision values or levels", depending on the number of quantization bits used to quantize the symbols. Soft-decision data is further processed at the soft-decision processing unit 4, de-puncturing circuit 5, de-interleaving circuit 6 and input to the decoder 7. The use of soft decision data can provide a better signal-to-noise ratio (SNR) performance at the same bit error level. This is because it contains information on the reliability of the received signal bits.

Figure 2 is a graph illustrating an exemplary histogram distribution of the received signal soft-decision data at the output of a demodulator or an equalizer. It represents the number of received signal soft-decision levels (Y axis) spread between a range of "$\pm 2$" (X Axis). The received signal soft-decision values greater or smaller than the "$\pm 2$" range have been assigned to the positive limit "+2" and negative limit "-2" respectively. In the example of figure 2, "256" soft-decision levels are considered which correspond to a "8" bit quantization.

The histogram gives an appreciation of the population density of the received signal when two symbols "0", "1" are transmitted. Usually, because of the influence of the transmission channel, the received symbol energy spreads out so that the energy from one symbol flows into, or interferes with, the other.

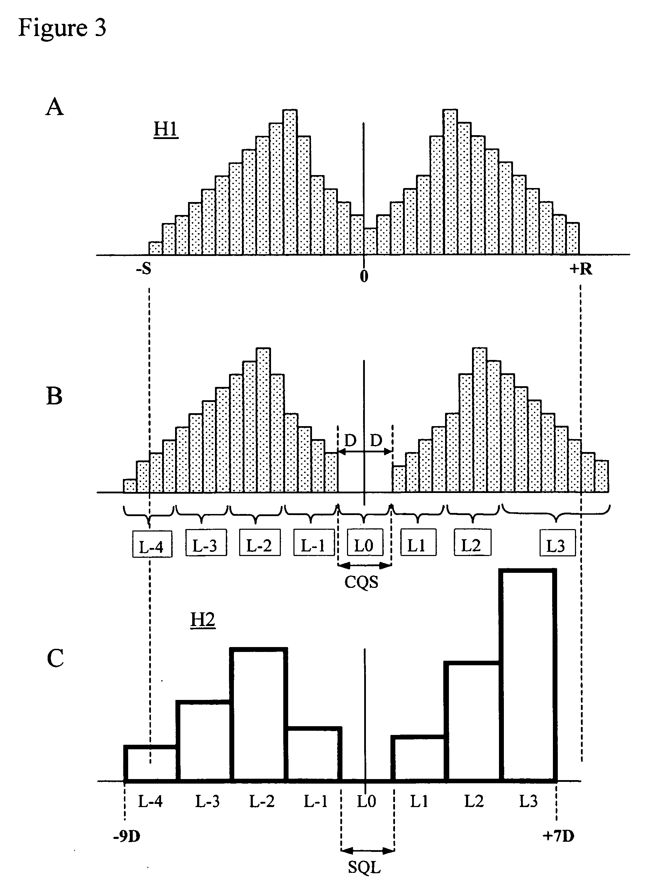

Figure 3 A, B, C shows by way of histogram H 1, H2 graph example, a processing method of soft-decision values at the soft-decision processing unit 4 of Figure 1 according to a first embodiment of the invention. The histogram H1 is the input to the soft-decision processing unit and the histogram H2 is the corresponding output after processing of the input soft-decision values according to the first embodiment of the invention.

In Figure 3A, histogram H1 represents a number of received signal soft-decision values (Y axis) spread between a range -S to +R (X axis), at the input of the soft-decision processing unit. In the example of Figure 3, "32" soft-decision values are considered which correspond to a "5" bit quantization.

According to a first preferred embodiment of the invention, the received signal "32" soft-decision values of Figure 3A are shifted away from the zero value 0 by a shift step D, which is preferably one half of the coarse quantization step CQS applied to the received signal soft-decision values. In the example of Figure 3, a "3" bit coarse quantization is applied to the "32" soft-decision values so that the histogram H2 of Figure 3C, at the output of the soft-decision processing unit, is represented by, no longer "32" values, but "8" soft-decision values L-4 to L3.

In Figure 3B we see how the input soft-decision values are shifted away from the zero value 0 by step D, positive values moving in the increasing positive X axis direction and negative values moving in the increasing negative X axis direction, this could be done for example by adding a shift step D to the soft-decision values greater than the zero value 0 and subtracting a shift step D to the soft-decision values smaller than the zero value 0. After that, a coarse "3" bit quantization in "8" soft-decision levels L-4 to L3 is applied.

As mentioned above, the shift step D is preferably one half of the coarse quantization step CQS applied and can generally be calculated by the equation

$$D = \frac{S}{2^n}$$

where "S" is the absolute value of the negative limit of the soft-decision value range -S to +R, and "n" is the number of the coarse quantization bits applied to the input soft-decision values. It shall be understood that other values of the shift step D around the preferred value can be applied to shift the input soft-decision values away from the zero value 0 depending on the decoding performance that wants to be achieved.

Figure 3C shows an example of how the histogram H2 at the output of the soft-decision processing unit 4 would look like after processing of the input soft-decision values according to the first embodiment of the invention. As we can see, no zero soft-decision values L0 are present at the output of the soft-decision processing unit.

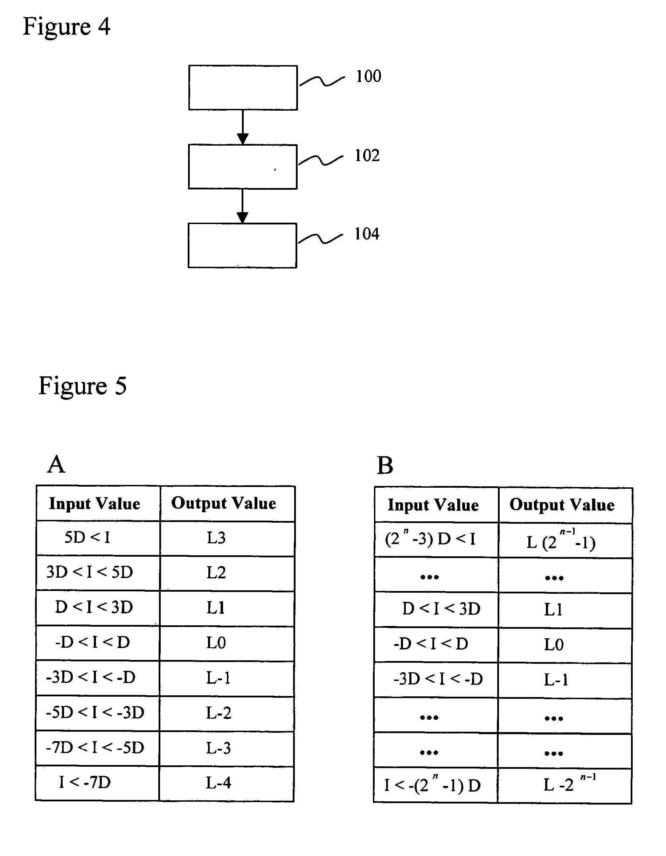

Figure 4 is a flow chart illustrating an operating process of a soft-decision processing unit in charge of processing a plurality of input soft-decision values according to a first embodiment of the invention.

The soft-decision processing unit operates according to the invention as described in the example of Figure 3. In a first step 100, the soft-decision processing unit receives the soft-decision values and in the subsequent step 102 it shifts said soft-decision values by a shift step away from the zero level. Finally, in a further step 104 the said shifted soft-decision values are quantized according to a certain quantization input- output relationship.

Preferably the quantization in step 104 is a coarse quantization, which means that fewer quantization bits and soft-decision values are used to represent the signal than the ones received. Better performances of the decoding means are achieved for example when the signal at the input of the soft-decision processing unit has at least a three bit higher quantization order than the quantization done in the soft-decision processing unit, e. g. "8" bit quantization at the input and "5" bit quantization at the output.

Figure 5 A,B shows quantization input-output relationship tables for quantization of soft-decision values at a soft-decision processing unit according to the invention.

Figure 5A illustrates a "3" bit quantization input-output relationship in which a certain range of input values I are assigned to one of "8" soft-decision output values L-4 to L3. Soft-decision output value L0 corresponds to a zero signal value and soft-decision output values L-4 and L3 correspond to a most negative and most positive signal value respectively. A soft-decision output value L0 is applied to all input values in a rage between ±D, being D the shift step.

Figure 5B illustrates a general rule for the calculation of a soft-bit quantization input-output relationship which is applied to the shifted soft-decision values according to the invention where n is the number of quantization bits used for the coarse quantization in the soft-decision processing unit and "D" is the shift step calculated above, $D = \frac{S}{2^n}$. It is understood that S is common to the input and the output of the soft-decision processing unit.

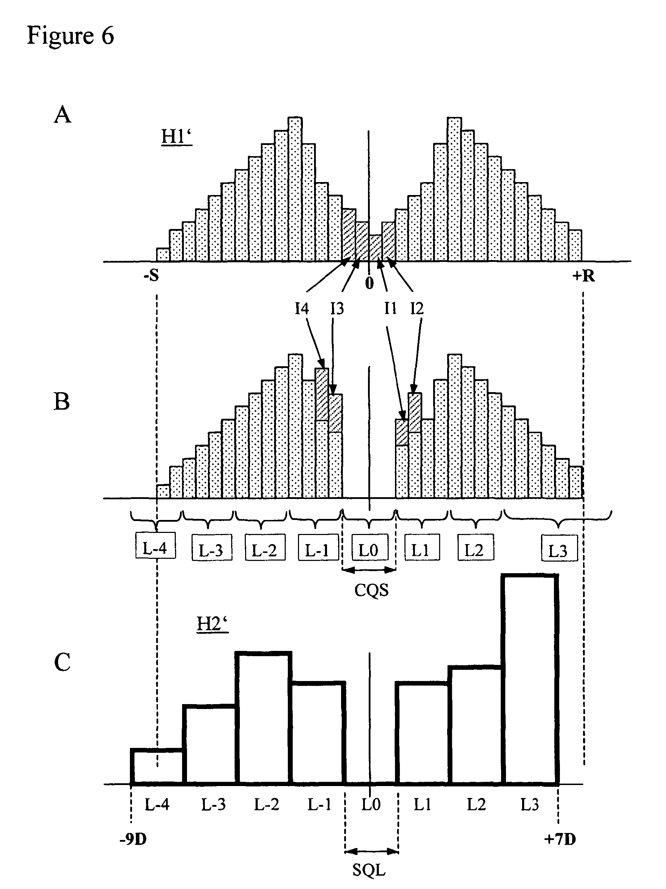

Figure 6 A, B, C shows by way of histogram H1', H2' graph example, a processing method of soft-decision values at the soft-decision processing unit 4 of Figure 1 according to a second embodiment of the invention. The histogram H1 is the input to the soft-decision processing unit and the histogram H2 is the corresponding output after processing of the input soft-decision values according to the second embodiment of the invention.

In Figure 6A, histogram H1' represents a number of received signal soft-decision values (Y axis) spread between a range -S to +R (X axis), at the input of the soft-decision processing unit. In the example of Figure 6, "32" soft-decision values are considered which correspond to a "5" bit quantization.

According to a second preferred embodiment of the invention, the received signal soft-decision values I1 to 14 of Figure 6A that would fall into the zero value of the soft-decision processing unit coarse quantization are shifted away from the zero value 0 by a shift step D, which is preferably one half of the coarse quantization step CQS applied to the received signal soft-decision values. In the example of Figure 6, a "3" bit coarse quantization is applied to the "32" soft-decision values so that the histogram H2' of Figure 6C, at the output of the soft-decision processing unit, is represented by "8" soft-decision values L-4 to L3.

In Figure 6B we see how these input soft-decision values I1 to 14 are shifted away from the zero level 0 by step D, positive values I1 and I2 moving in the increasing positive X axis and negative values I3 and I4 moving in the increasing negative X axis. After that, a coarse "3" bit quantization in "8" soft-decision levels L-4 to L3 is applied.

As mentioned above, the shift step D is preferably one half of the coarse quantization step CQS applied and can generally be calculated by the equation

$$D = \frac{S}{2^n}$$

where "S" is the absolute value of the negative limit of the soft-decision value range -S to +R, and "n" is the number of the coarse quantization bits applied to the input soft-decision values. It shall be understood that other values of the shift step D around the preferred value can be applied to shift the input soft-decision values away from the zero level 0 depending on the decoding performance that wants to be achieved.

Figure 6C shows an example of how the histogram H2' at the output of the soft-decision processing unit would look like after processing of the input soft-decision values according to the second embodiment of the invention. As we can see, no zero soft-decision values L0 are present at the output of the soft-decision processing unit.

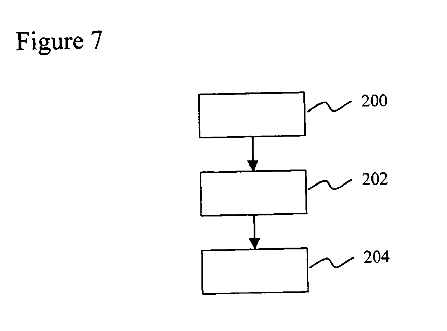

Figure 7 is a flow chart illustrating an operating process of a soft-decision processing unit in charge of processing a plurality of input soft-decision values according to a second embodiment of the invention.

The soft-decision processing unit operates according to the invention as described in the example of Figure 6. In a first step 200, the soft-decision processing unit receives the soft-decision values and in the subsequent step 202 it shifts a number of such input soft-decision values, preferably those that would fall into the zero value of the soft-decision processing unit coarse quantization, I1 to 14 of Figure 6, away from the soft-decision zero value 0. Finally, in a further step 204 resulting soft-decision values are quantized according to a certain quantization input-output relationship.

Preferably the quantization in step 204 is a coarse quantization, which means that fewer quantization bits and soft-decision values are used to represent the signal than the ones received. Better performances of the decoding means are achieved for example when the signal at the input of the soft-decision processing unit has at least a three bit higher quantization order than the quantization done in the soft-decision processing unit, e. g. "8" bit quantization at the input and "5" bit quantization at the output.

Also, the coarse quantization input-output relationship applied at the soft-decision processing unit is calculated according to the general rule illustrated in Figure 5B.

For the sake of generalization, it is understood that the method and device for soft-decision processing described herein can be implemented in any type of communication systems, such as software radio systems, high-definition television systems, etc. besides the already mentioned wireless communication systems as GSM, UMTS or the like. Further, the method and the device of the invention can be implemented in integrated circuits (ICs) such as application specific ICs (ASICs) or digital signal processors (DSPs), or in software form, within receivers, transceivers or the like. Finally, the soft-decision processing method may be employed at any convenient location within the data communication system.

## Claims

1. Method for soft-decision decoding of punctured convolutional codes, comprising the steps of, before depuncturing:

    - receiving a number of quantized signal soft-decision values, derived from demodulation or equalization, spread across a range having a maximum value +R, a minimum value -S, and a value corresponding to the center 0 of that range (100, 200),
    - shifting a number of signal soft-decision values by a shift step D away from said center value (102, 202), values lower than said center value being shifted in the direction towards the range minimum value -S and values greater than said center value being shifted in the direction towards the maximum range value +R, and
    - quantizing the shifted signal soft-decision values with fewer bits than the number used to quantize the received signal soft-decision values according to a determined quantization input-output relationship (104, 204), wherein the determined input-output relationship is defined by a coarse quantization step CQS, wherein said shift step D is determined by said coarse quantisation step CQS.

2. The method for soft-decision decoding of punctured convolutional codes of claim 1 wherein all received signal soft-decision values are shifted by a shift step D away from the center value 0.

3. The method for soft-decision decoding of punctured convolutional codes of claim 1 wherein only those received signal soft-decision values which fall inside a negative to positive shift step D range from the center value 0 are shifted by a shift step D.

4. The method for soft-decision decoding of punctured convolutional codes of claim 1 wherein the shift step D is one half of the coarse quantization step CQS applied to the signal soft-decision values after shifting.

5. The method for soft-decision decoding of punctured convolutional codes of claim 1 wherein the determined quantization input-output relationship has a zero output soft-decision value L0 corresponding to input soft-decision input values I between a negative to positive shift step D range.

6. The method for soft-decision decoding of punctured convolutional codes of claim 1 wherein said steps of the method are carried out after demodulation of the received signal and before de-puncturing of the signal soft-decision values.

7. A receiver system (Rx) of a wireless communication system comprising means for receiving and decoding of punctured convolutional codes and comprising a soft-decision processing unit (4), located after a demodulator (2) or an equalizer (3) and before a de-puncturing circuit (5), adapted to

   - receive a number of quantized signal soft-decision values derived from demodulation or equalization spread across a range having a maximum value +R, a minimum value -S, and a value corresponding to the center 0 of that range (100, 200),
   - shift a number of signal soft-decision values by a shift step D away from said center value (102, 202), values lower than said center value being shifted in the direction towards the range minimum value -S and values greater than said center value being shifted in the direction towards the maximum range value +R, and
- quantize the shifted signal soft-decision values with fewer bits than the number used to quantize the received signal soft-decision values according to a determined quantization input-output relationship (104, 204), wherein the determined input-output relationship is defined by a coarse quantization step CQS, wherein said shift step D is determined by said coarse quantization step CQS.

8. Base station of a wireless communication system comprising the receiver system (Rx) of claim 7.

9. Mobile station of a wireless communication system comprising the receiver system (Rx) of claim 7.

**Patentansprüche**

1. Verfahren zur Soft-Decision-Decodierung von punktierten Faltungscodes, vor der Depunktierung die folgenden Schritte umfassend:

   - Empfangen einer Anzahl von aus einer Demodulation oder Entzerrung abgeleiteten quantisierten Soft-Decision-Signalwerten, welche über einen Bereich mit einem Höchstwert +R, einem Mindestwert -S, und einem der Mitte 0 dieses Bereiches (100, 200) entsprechenden Wert verteilt sind,
   - Verschieben einer Anzahl von Soft-Decision-Signalwerten unter Ausführen eines Verschiebeschritts D weg von dem besagten Mittelwert (102, 202), wobei Werte, die unter dem besagten Mittelwert liegen, in Richtung des Mindestwertes -S des Bereiches, und Werte, die über dem besagten Mittelwert liegen, in Richtung des Höchstwertes des Bereichs +R verschoben werden, und
   - Quantisieren der verschobenen Soft-Decision-Signalwerte mit weniger Bits als die Anzahl, welche für die Quantisierung der empfangenen Soft-Decision-Signalwerte verwendet wird, gemäß einer ermittelten quantisierten Eingangs-Ausgangs-Beziehung (104, 204), wobei die ermittelte Eingangs-AusgangsBeziehung durch einen Grobquantisierungsschritt CQS definiert wird, wobei der besagte Verschiebeschritt D anhand des besagten Grobquantisierungsschrittes CQS ermittelt wird.

2. Das Verfahren zur Soft-Decision-Decodierung von punktierten Faltungscodes nach Anspruch 1, wobei alle empfangenen Soft-Decision-Signalwerte durch einen Verschiebeschritt D von dem Mittelwert 0 weg verschoben werden.

3. Das Verfahren zur Soft-Decision-Decodierung von punktierten Faltungscodes nach Anspruch 1, wobei nur solche empfangene Soft-Decision-Signalwerte, welche in einen Bereich des Verschiebeschrittes D von negativ zu positiv von dem Mittelwert 0 fallen, durch einen Verschiebeschritt D verschoben werden.

4. Das Verfahren zur Soft-Decision-Decodierung von punktierten Faltungscodes nach Anspruch 1, wobei der Verschiebeschritt D eine Hälfte des auf die Soft-Decision-Signalwerte angewandten Grobquantisierungsschritts CQS nach dem Verschieben beträgt.

5. Das Verfahren zur Soft-Decision-Decodierung von punktierten Faltungscodes nach Anspruch 1, wobei die ermittelte quantisierte Eingangs-Ausgangsbeziehung einen Null-Ausgang-Soft-Decision-Wert L0 aufweist, welcher eingegebenen Soft-Decision-Eingangswerten I zwischen einem Bereich des Verschiebeschritts D von negativ zu positiv entspricht.

6. Das Verfahren zur Soft-Decision-Decodierung von punktierten Faltungscodes nach Anspruch 1, wobei die besagten Schritte des Verfahrens nach der Demodulation des empfangenen Signals und vor der Depunktierung der Soft-Decision-Signalwerte ausgeführt werden.

7. Ein Empfängersystem (Rx) eines drahtlosen Kommunikationssystems mit Mitteln zum Empfangen und Decodieren von punktierten Faltungscodes, umfassend eine Soft-Decision-Verarbeitungseinheit (4), welche einem Demodulator (2) oder einem Entzerrer (3) nachgeschaltet und einer Depunktierungsschaltung (5) vorgeschaltet ist, ausgelegt für

- den Empfang einer Anzahl von aus einer Demodulation oder Entzerrung abgeleiteten quantisierten Soft-Decision-Signalwerten, welche über einen Bereich mit einem Höchstwert +R, einem Mindestwert -S, und einem der Mitte 0 dieses Bereiches (100, 200) entsprechenden Wert verteilt sind,
- das Verschieben einer Anzahl von Soft-Decision-Signalwerten unter Ausführen eines Verschiebeschritts D weg von dem besagten Mittelwert (102, 202), wobei Werte, die unter dem besagten Mittelwert liegen, in Richtung des Mindestwertes -S des Bereiches, und Werte, die über dem besagten Mittelwert liegen, in Richtung des Höchstwertes des Bereichs +R verschoben werden, und
- das Quantisieren der verschobenen Soft-Decision-Signalwerte mit weniger Bits als die Anzahl, welche für die Quantisierung der empfangenen Soft-Decision-Signalwerte verwendet wird, gemäß einer ermittelten quantisierten Eingangs-Ausgangs-Beziehung (104, 204), wobei die ermittelte Eingangs-AusgangsBeziehung durch einen Grobquantisierungsschritt CQS definiert wird, wobei der besagte Verschiebeschritt D anhand des besagten Grobquantisierungsschrittes CQS ermittelt wird.

8. Basisstation eines drahtlosen Kommunikationssystems, welche das Empfängersystem (Rx) nach Anspruch 7 umfasst.

9. Mobilstation eines drahtlosen Kommunikationssystems, welche das Empfängersystem (Rx) nach Anspruch 7 umfasst.

**Revendications**

1. Procédé de décodage à décision non stricte de codes de convolution perforés, comprenant les étapes suivantes avant la dé-perforation :

- réception d'un nombre de valeurs à décision non stricte de signal quantifié, dérivées d'une démodulation ou d'une égalisation, réparties sur une plage ayant une valeur maximale +R, une valeur minimale -S et une valeur correspondant au centre 0 de cette plage (100, 200),
- décalage d'un nombre de valeurs à décision non stricte de signal au moyen d'une étape de décalage D à distance de ladite valeur centrale (102, 202), les valeurs inférieures à ladite valeur centrale étant décalée en direction de la valeur minimale de la plage -S et les valeurs supérieures à ladite valeur centrale étant décalées en direction de la valeur maximale de la plage +R, et
- quantification des valeurs à décision non stricte de signal décalées avec moins de bits que le nombre utilisé pour quantifier les valeurs à décision non strictes de signal reçues conformément à une relation d'entrée-sortie de quantification déterminée (104, 204), dans lequel la relation d'entrée-sortie déterminée est définie par une étape de quantification grossière CQS, dans lequel ladite étape de décalage D est déterminée par ladite étape de quantification grossière CQS.

2. Procédé de décodage à décision non stricte de codes de convolution perforés selon la revendication 1, dans lequel toutes les valeurs à décision non-stricte de signal reçues sont décalées par une étape de décalage D à distance de la valeur centrale 0.

3. Procédé de décodage à décision non stricte de codes de convolution perforés selon la revendication 1, dans lequel seules celles des valeurs à décision non stricte de signal reçues qui tombent dans une plage d'étape de décalage D négative à positive par rapport à la valeur centrale 0 sont décalées par une étape de décalage D.

4. Procédé de décodage à décision non stricte de codes de convolution perforés selon la revendication 1, dans lequel l'étape de décalage D est la moitié de l'étape de quantification grossière CQS appliquée aux valeurs à décision non stricte de signal après le décalage.

5. Procédé de décodage à décision non stricte de codes de convolution perforés selon la revendication 1, dans lequel la relation d'entrée-sortie de quantification déterminée présente une valeur à décision non stricte égale à zéro L0 correspondant à des valeurs d'entrée à décision non stricte I enture une plage d'étape de décalage D négative à positive.

6. Procédé de décodage à décision non stricte de codes de convolution perforés selon la revendication 1, dans lequel lesdites étapes du procédé sont exécutées après la démodulation du signal reçu et avant la dé-perforation des valeurs à décision non stricte du signal.

7. Système de réception (Rx) d'un système de communication sans fil, comprenant des moyens pour recevoir et décoder des codes de convolution perforés et comprenant une unité de traitement à décision non stricte (4), située après un démodulateur (2) ou un égaliseur (3) et avant un circuit de dé-perforation (5), adapté pour

   - recevoir un nombre de valeurs à décision non stricte de signal quantifié, dérivées d'une démodulation ou d'une égalisation, réparties sur une plage ayant une valeur maximale +R, une valeur minimale -S et une valeur correspondant au centre 0 de cette plage (100, 200),
   - décaler un nombre de valeurs à décision non stricte de signal au moyen d'une étape de décalage D à distance de ladite valeur centrale (102, 202), les valeurs inférieures à ladite valeur centrale étant décalées en direction de la valeur minimale de la plage -S et les valeurs supérieures à ladite valeur centrale étant décalées en direction de la valeur maximale de la plage +R, et
   - quantifier les valeurs à décision non stricte de signal décalées avec moins de bits que le nombre utilisé pour quantifier les valeurs à décision non stricte de signal reçues conformément à une relation d'entrée-sortie de quantification déterminée (104, 204), dans lequel la relation d'entrée-sortie déterminée est définie par une étape de quantification grossière CQS, dans lequel ladite étape de décalage D est déterminée par ladite étape de quantification grossière CQS.

8. Station de base d'un système de communication sans fil, comprenant le système de réception (Rx) selon la revendication 7.

9. Station mobile d'un système de communication sans fil, comprenant le système de réception (Rx) selon la revendication 7.

# Figure 1

Rx

# Figure 2

# Figure 3

A

H1

-S 0 +R

B

D D

L-4 L-3 L-2 L-1 L0 L1 L2 L3

CQS

H2

C

L-4 L-3 L-2 L-1 L0 L1 L2 L3

-9D +7D

SQL

# Figure 4

# Figure 5

## A

| Input Value | Output Value |
|---|---|
| $5D < I$ | L3 |
| $3D < I < 5D$ | L2 |
| $D < I < 3D$ | L1 |
| $-D < I < D$ | L0 |
| $-3D < I < -D$ | L-1 |
| $-5D < I < -3D$ | L-2 |
| $-7D < I < -5D$ | L-3 |
| $I < -7D$ | L-4 |

## B

| Input Value | Output Value |
|---|---|
| $(2^{n}-3)D < I$ | $L(2^{n-1}-1)$ |
| ••• | ••• |
| $D < I < 3D$ | L1 |
| $-D < I < D$ | L0 |
| $-3D < I < -D$ | L-1 |
| ••• | ••• |
| ••• | ••• |
| $I < -(2^{n}-1)D$ | $L-2^{n-1}$ |

# Figure 6

A

H1'

-S     0     +R

I4   I3    I1   I2

B

| L-4 | L-3 | L-2 | L-1 | L0 | L1 | L2 | L3 |

CQS

H2'

C

L-4    L-3    L-2    L-1    L0    L1    L2    L3

-9D                           +7D

SQL

Figure 7

```
┌──────────────┐
│              │  〜 200
└──────┬───────┘
       │
       ▼
┌──────────────┐
│              │  〜 202
└──────┬───────┘
       │
       ▼
┌──────────────┐
│              │  〜 204
└──────────────┘
```

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 2004056058 A